# EUROPÄISCHE PATENTSCHRIFT

(11) **EP 4 411 393 B1**
(45) Veröffentlichungstag und Bekanntmachung des Hinweises auf die Patenterteilung: **25.12.2024**
(21) Anmeldenummer: 23154344.8
(22) Anmeldetag: 31.01.2023
(51) Int. Cl.: G01R 21/04, H01R 13/66, H01R 24/54

(54) **ADAPTERVORRICHTUNG UND VERFAHREN ZUR VERMESSUNG DER SIGNALLEISTUNG IN EINER KOAXIALVERBINDUNG**
ADAPTER DEVICE AND METHOD FOR MEASURING SIGNAL POWER IN A COAXIAL CONNECTION
DISPOSITIF ADAPTATEUR ET PROCÉDÉ DE MESURE DE LA PUISSANCE DE SIGNAL DANS UNE LIAISON COAXIALE

(43) Veröffentlichungstag der Anmeldung: 07.08.2024
(73) Patentinhaber: SICK AG, 79183 Waldkirch (DE)
(72) Erfinder: Pudenz, Florian, 22359 Hamburg (DE); Sock, Björn, 21629 Neu Wulmstorf (DE)

(56) Entgegenhaltungen:
- EP-A1- 2 442 255
- CN-U- 207 440 171
- US-A- 2 929 993
- US-A1- 2011 161 050

## Beschreibung

Die Erfindung betrifft eine Adaptervorrichtung und ein Verfahren zur Vermessung der Signalleistung in einer Koaxialverbindung von einer RFID-Lesevorrichtung zu einerzweiten Vorrichtung, insbesondere Antenne, nach dem Oberbegriff von Anspruch 1 beziehungsweise 9.

RFID-Leser dienen der Identifikation von Objekten und Waren und werden unter anderem eingesetzt, um logistische Bewegungen zu automatisieren. An einem Identifikationspunkt, vor allem bei einem Wechsel des Besitzers der Ware oder einem Wechsel des Transportmittels, werden an den Waren befestigte RFID-Transponder ausgelesen und gegebenenfalls Informationen in den Transponder zurückgeschrieben. Dies führt zu schnellen und nachvollziehbaren Logistikbewegungen. Die erfassten Informationen werden verwendet, um die Weiterleitung und Sortierung von Gütern und Produkten zu steuern. Wichtige Anwendungen für die automatische Identifikation sind logistische Verteilerzentren, etwa von Paketversendern, oder die Gepäckaufgabe in Flughäfen.

RFID-Transponder können prinzipiell aktiv sein, also eine eigene Energieversorgung aufweisen und selbstständig elektromagnetische Strahlung erzeugen. In der Praxis eignen sich diese Transponder für die Logistik aber weniger, weil durch die Energieversorgung die Stückpreise solcher Transponder nicht das für den Massenmarkt erforderliche geringe Niveau erreichen können. Deshalb werden zumeist passive Transponder ohne eigene Energieversorgung eingesetzt. In beiden Fällen wird durch elektromagnetische Strahlung des Lesegerätes der Transponder zur Abstrahlung der gespeicherten Information angeregt, wobei passive Transponder die notwendige Energie aus der Sendeenergie des Lesesystems beziehen. In dem etablierten Ultrahochfrequenzstandard ISO 18000-6 werden passive Transponder nach dem Backscatter-Verfahren ausgelesen.

RFID-Geräte verwenden interne oder externe Antennen, wobei eine externe Antenne in der Regel nachträglich angeschlossen wird. Dabei werden Koaxialverbindungen und Koaxialleitungen verwendet, deren Eigenschaften unbekannt sind. Dafür gibt es verschiedene Gründe: Die Eigenschaften können von vorneherein nicht vermessen oder spezifiziert sein. Selbst bei einer vorkonfektionierten Koaxialleitung kann es durch Effekte wie mechanische Beschädigung bei der Installation oder Alterung im Betrieb zu Abweichungen von der werkseitig angegebenen Spezifikation kommen. Sind aber die Übertragungsverluste beziehungsweise Werte der Kabeldämpfung nicht bekannt, so muss vorsichtshalber von einer verlustlosen Koaxialverbindung ausgegangen werden, und deshalb darf die Sendeleistung höchstens auf den maximal erlaubten Wert eingestellt werden. Das schöpft aber die erlaubte Sendeleistung nicht aus, denn die real erreichte Sendeleistung wird durch die Übertragungsverluste niedriger, was wiederum die maximale Lesereichweite verringert.

Aus EP 2 712 021 A1 ist eine Antenne für ein Schreib-/Lesegerät für RFID-Anordnungen bekannt. Die Antenne ist mit einem Datenspeicher mit Typinformationen und/oder Eigenschaftsinformationen ausgestattet und weist ferner eine Messeinrichtung zur Bestimmung mindestens eines Wertes der Feldstärke oder Leistung eines in die Antenne eingespeisten Hochfrequenzsignals auf. Die Funktionalität ist damit an besondere Antennen gebunden, es ist nicht möglich, beliebige Antennen zu verwenden. In einer Ausführungsform kann der Inhalt des Datenspeichers mittels eines getakteten Kurzschließens der Antennenleitung bitweise übertragen werden. Während der Perioden, in denen ein Kurzschluss erzeugt wird, kann ein entsprechend ausgerüstetes Schreib-/Lesegerät weitere Leitungsparameter wie eine Kabeldämpfung oder an der Antenne auftretende Reflexionsverluste ausmessen. Dafür bedarf es neben einer besonderen Antenne dann auch noch eines besonderen Schreib-/Lesegeräts, das diese Messfunktionalität mitbringt.

In der EP 2 442 255 A1 wird eine RFID-Lesevorrichtung beschrieben, deren Antenne einen Datenträger aufweist, in dem für eine erleichterte Installation der RFID-Lesevorrichtung die Antennenparameter abgelegt sind, wobei der Datenträger ein RFID-Transponder sein kann.

Die US 10 181 656 B2 befasst sich mit einer Antenneneinheit, die eine Antenne und einen Koaxialverbinder aufweist. Der Koaxialverbinder weist einen internen Speicher auf, der es ermöglicht, die angeschlossene Antenne zu identifizieren und der über das Koaxialkabel versorgt wird. Übertragungsverluste der Antennenleitung werden nicht diskutiert, und eine Vermessung von Parametern ist insgesamt nicht vorgesehen.

Die US 10 339 346 B2 offenbart eine Antenne mit integriertem RFID-IC, der es ermöglicht, jeweils eines von mehreren Antennenelementen mittels Hochfrequenzschaltern auszuwählen. Dadurch können beispielsweise Resonanzfrequenz oder Richtwirkung der Antenne angepasst werden. Erneut werden weder Übertragungsverluste der Antennenleitung noch allgemein eine Möglichkeit zur Vermessung von Eigenschaften angesprochen.

Aus der US 2 929 993 A ist eine Messvorrichtung zur Bestimmung einer Spitzenleistung eines Hochfrequenzsignals in einer Koaxialleitung bekannt. Die Messvorrichtung weist einen Leitungsabschnitt auf, der in die Koaxialleitung eingesetzt wird.

Es ist daher Aufgabe der Erfindung, die Einrichtung einer RFID-Lesevorrichtung weiter zu verbessern.

Diese Aufgabe wird durch eine RFID-Lesevorrichtung und ein Verfahren zur Vermessung der Signalleistung in einer Koaxialverbindung von einer RFID-Lesevorrichtung zu einer zweiten Vorrichtung, insbesondere Antenne, nach Anspruch 1 beziehungsweise 9 gelöst. Eine RFID-Lesevorrichtung, kurz ein RFID-Leser (RFID reader), ist trotz des verkürzten Namens meist auch zum Schreiben von Daten auf einen RFID-Transponder in der Lage. Eine erste Adaptervorrichtung ist in eine Koaxialverbindung zwischen der Lesevorrichtung und der zweiten Vorrichtung in die Koaxialverbindung eingesetzt, mit der die zweite Vorrichtung an die RFID-Lesevorrichtung angeschlossen ist. Die zweite Vorrichtung ist vorzugsweise eine Antenne, und im Folgenden steht die Antenne immer wieder stellvertretend für die zweite Vorrichtung. Die Koaxialverbindung ist vorzugsweise eine Koaxialleitung beziehungsweise eine Antennenleitung, wobei alternativ ein direkter Anschluss der zweiten Vorrichtung an die RFID-Lesevorrichtung denkbar ist. Die Koaxialverbindung überträgt das Signal, dessen Signalleistung gemessen werden soll, vorzugsweise ein Hochfrequenzsignal oder RFID-Signal. Die Messung der Signalleistung ist bevorzugt nur ein Zwischenergebnis, das eigentliche Ziel ist dann eine abgeleitete Größe, insbesondere die Bestimmung des Übertragungsverlusts beziehungsweise der Dämpfung der Koaxialverbindung.

Die Adaptervorrichtung weist einen ersten Koaxialanschluss und einen zweiten Koaxialanschluss zum Einsetzen in die Koaxialverbindung auf. Im eingesetzten Zustand ist demnach die Adaptervorrichtung beidseitig mit dem ersten Koaxialanschluss und dem zweiten Koaxialanschluss an die Koaxialverbindung angeschlossen, so dass die Koaxialverbindung nun durch die Adaptervorrichtung verläuft. Eine Messeinheit bestimmt die hin- und/oder rücklaufende Signalleistung des durch die Adaptervorrichtung propagierenden Signals.

Die Adaptervorrichtung kann wahlweise nachträglich in die Koaxialverbindung eingesetzt oder wieder von dort entfernt werden. Der erste Koaxialanschluss und der zweite Koaxialanschluss sind dafür lösbar ausgestaltet. Beispielsweise eignet sich eine Steckverbindung, die durch Verschrauben oder dergleichen gesichert werden kann, wie im Beispiel eines TNC oder R-TNC-Anschlusses, der für Antennen und Koaxialleitungen verbreitet ist.

Die erste Adaptervorrichtung ist mit ihrem ersten Koaxialanschluss und zweiten Koaxialanschluss in die Koaxialverbindung eingesetzt, wobei die erste Adaptervorrichtung an einem bezüglich der RFID-Lesevorrichtung fernen Ende des zu vermessenden Abschnitts der Koaxialverbindung angeordnet ist. Es sind verschiedene Konstellationen denkbar, wo der erste Koaxialanschluss und der zweite Koaxialanschluss verbunden sind. Der erste Koaxialanschluss kann direkt mit der RFID-Lesevorrichtung oder an einem Ende einer Koaxialleitung der Koaxialverbindung angeschlossen sein. Entsprechend kann der zweite Koaxialanschluss direkt mit der zweiten Vorrichtung oder einem Ende einer Koaxialleitung der Koaxialleitung angeschlossen sein. Sofern die Koaxialleitung mehrere Teilabschnitte aufweist, kann das Ende der Koaxialleitung ebenso ein Ende eines Teilabschnitts bedeuten. Als nochmals weitere Alternative kann die RFID-Lesevorrichtung ursprünglich direkt mit der zweiten Vorrichtung verbunden sein, in diesem Fall ersetzt dann die erste Adaptervorrichtung die direkte Verbindung. Die erste Adaptervorrichtung bildet das bezüglich der RFID-Lesevorrichtung ferne Ende des zu vermessenden Abschnitts der Koaxialverbindung.

Die Erfindung hat den Vorteil, dass die Funktionalität der Adaptervorrichtung zu einem bestehenden System einer RFID-Lesevorrichtung und daran angeschlossener zweite Vorrichtung ergänzt wird und die Erfindung damit bei beliebigen RFID-Lesevorrichtungen und zweite Vorrichtungen zugänglich ist. Eine eigene Messfunktionalität in einer RFID-Lesevorrichtung oder einer daran angeschlossenen Antenne benötigt. Parameter der Koaxialverbindung können auf einfache Weise bestimmt werden, insbesondere die Dämpfung beziehungsweise die Übertragungsverluste. In gleicher Weise werden Aussagen über die Qualität der zweiten Vorrichtung möglich. Im Betrieb der RFID-Lesevorrichtung kann die Sendeleistung unter Berücksichtigung von Übertragungsverlusten in der Koaxialverbindung passend eingestellt werden. Dadurch können maximal zulässige Signalpegel ausgereizt und dabei verlässlich eingehalten werden, um die Lesereichweite zu optimieren. Im Falle kaskadierter Koaxialverbindungen können Messungen an verschiedenen Stellen im Signalpfad erfolgen, um fehlerhafte Komponenten zu lokalisieren. Die Adaptervorrichtung kann nacheinander in unterschiedlichen Koaxialverbindung eingesetzt werden, um so kostengünstig verschiedene Systeme von RFID-Lesevorrichtungen und zweiten Vorrichtungen zu bewerten. Die Adaptervorrichtung wird beispielsweise nur während der Installation oder bei einer Wartung benötigt. Bleibt die Adaptervorrichtung andererseits eingesetzt, so können durch regelmäßige Vermessung frühzeitig Verschlechterungen erkannt werden (predictive maintenance).

Die Messeinheit ist bevorzugt dafür ausgebildet, einen Maximalwert der Signalleistung zu bestimmen. Damit werden, anders als beispielsweise bei einer Durchschnittsbildung, Aussagen über die Einhaltung einer zulässigen Maximalleistung unabhängig von Modulationen des Signals während der Messung der Signalleistung.

Die Adaptervorrichtung weist bevorzugt eine Energieversorgungseinheit auf, mit der sich die Adaptervorrichtung aus dem Signal auf der Koaxialverbindung propagierenden Signal selbst versorgt. Eine Batterie oder dergleichen ist damit nicht erforderlich. Die Energieversorgungseinheit kann auf Phantomspeisung beziehungsweise Fernspeisung basieren und dafür beispielsweise ein Bias-T aufweisen. Eine Alternative besteht darin, einen Energiespeicher, beispielsweise Kondensator, aus dem Signal aufzuladen und dafür beispielsweise einen Gleichrichter beziehungsweise eine Ladungspumpe zu verwenden, so dass keine Phantomspannung zur Verfügung gestellt werden muss.

Die Adaptervorrichtung weist bevorzugt einen Speicher auf, in dem die Messeinheit einen Messwert für die Signalleistung ablegt. Somit steht zumindest die zuletzt gemessene Signalleistung zum Auslesen zur Verfügung. Es können auch mehrere Messwerte oder daraus abgeleitete Größen gespeichert werden, insbesondere um damit genauere Ergebnisse aus mehreren Messungen zu erreichen.

Der Speicher ist bevorzugt mittels eines RFID-Protokolls auslesbar und weist insbesondere eine RFID-Transponder-Schaltung auf. Dadurch benötigt die RFID-Lesevorrichtung keine besondere Kommunikations- oder Datenschnittstelle für die Adaptervorrichtung, denn das RFID-Protokoll versteht eine RFID-Lesevorrichtung ohnehin. Ein Beispiel für das RFID-Protokoll ist das standardisierte EPC-Gen2-Protokoll oder ein Protokoll entsprechend dem eng verwandten, einleitend genannten Standard ISO 18000-6. Der Speicher kann dafür auf der gleichen, kostengünstig vorhandenen Technologie basieren wie ein RFID-Transponder, d.h. eine entsprechende RFID-Transponder-Schaltung aufweisen.

Die Messeinheit ist bevorzugt dafür ausgebildet, den Speicher auf ein dort abgelegtes Startsignal zu prüfen und bei Vorliegen eines Startsignals eine Messung der Signalleistung durchzuführen. Die Kommunikation zwischen der Adaptervorrichtung und der RFID-Lesevorrichtung ist damit ausgesprochen einfach über Zugriffe auf den Speicher realisiert, die keiner komplexeren Abstimmung oder Synchronisation bedürfen. Die RFID-Lesevorrichtung meldet ihren Bedarf für eine Messung des Signalpegel über das Startsignal an. Die Messeinheit stellt diesen Bedarf anhand des Startsignals fest, führt die Messung durch und legt das Messergebnis für einen Zugriff der RFID-Lesevorrichtungen zu einem beliebigen späteren Zeitpunkt wieder in dem Speicher ab.

Die Sendeleistung der RFID-Lesevorrichtung ist bevorzugt in der RFID-Lesevorrichtung bekannt, und die RFID-Lesevorrichtung ist dafür ausgebildet, einen Übertragungsverlust der Koaxialverbindung aus der bekannten Sendeleistung und einem Messwert der ersten Adaptervorrichtung zu bestimmen. In dieser Ausführungsform gibt es ein gewisses Vorwissen über die Signalleistung, nämlich wieviel Signal ursprünglich von der RFID-Lesevorrichtung erzeugt wird. Vorzugsweise ist die RFID-Lesevorrichtung angepasst, so dass diese ursprüngliche Signalleistung tatsächlich in die Koaxialverbindung eingespeist wird beziehungsweise ein entsprechender Anfangsverlust bekannt ist. Für den Übertragungsverlust der Koaxialverbindung, genau genommen des Abschnitts der Koaxialverbindung von der RFID-Lesevorrichtungen zur ersten Adaptervorrichtung, ist dann nur noch ein Vergleich der bekannten ursprünglichen Signalleistung mit einem entsprechenden Messwert der ersten Adaptervorrichtung erforderlich. Soll der Übertragungsverlust der gesamten Koaxialverbindung gemessen werden, so ist die erste Adaptervorrichtung möglichst fern der RFID-Lesevorrichtung direkt an der zweiten Vorrichtung anzuschließen.

Vorzugsweise ist eine zweite Adaptervorrichtung zur Vermessung der Signalleistung in der Koaxialverbindung vorgesehen, wobei die zweite Adaptervorrichtung an einem bezüglich der RFID-Lesevorrichtung nahen Ende des zu vermessenden Abschnitts der Koaxialverbindung angeordnet und die RFID-Lesevorrichtung dafür ausgebildet ist, einen Übertragungsverlust der Koaxialverbindung aus Messwerten der ersten Adaptervorrichtung und der zweiten Adaptervorrichtung zu bestimmen. Damit kann der Übertragungsverlust für eine beliebige RFID-Lesevorrichtung bestimmt werden, deren Sendeleistung nicht bekannt und die auch nicht notwendig an die Koaxialverbindung angepasst ist. Die zweite Adaptervorrichtung kann die zeitversetzt erneut verwendete erste Adaptervorrichtung sein, die nach einer ersten Messung von ihrer ursprünglichen Position gelöst und für eine zweite Messung an ihrer neuen Position in die Koaxialverbindung eingesetzt wird. Vorzugsweise sind jedoch zwei Adaptervorrichtung gleichzeitig in die Koaxialverbindung eingesetzt. Mit der ersten und zweiten Adaptervorrichtung wird durch Vergleich von deren beiden Messwerten der Übertragungsverlust zwischen den beiden Adaptervorrichtungen bestimmt. Um den Übertragungsverlust der ganzen Koaxialverbindung zu bestimmen, sind die Adaptervorrichtungen direkt an die zweite Vorrichtung beziehungsweise die RFID-Lesevorrichtung anzuschließen, mit der gesamten Koaxialverbindung zwischen den beiden Adaptervorrichtungen.

Für das erfindungsgemäße Verfahren zur Vermessung der Signalleistung in einer Koaxialverbindung von einer RFID-Lesevorrichtung zu einer zweiten Vorrichtung, insbesondere Antenne, ist mindestens eine erste Adaptervorrichtung mit ihrem ersten Koaxialanschluss und zweiten Koaxialanschluss lösbar in die Koaxialverbindung eingesetzt. Die erste Adaptervorrichtung ist am fernen Ende des zu vermessenden Abschnitts der Koaxialverbindung angeordnet, vorzugsweise direkt bei der zweiten Vorrichtung, d.h. mit ihrem zweiten Koaxialanschluss direkt an die zweite Vorrichtung angeschlossen. Die RFID-Lesevorrichtung startet eine Messung der Signalleistung, die erste Adaptervorrichtung bestimmt daraufhin die Signalleistung eines durch die erste Adaptervorrichtung propagierenden Signals der RFID-Lesevorrichtung, und dann liest die RFID-Lesevorrichtung einen Messwert der ersten Adaptervorrichtung aus. Es können Auswertungen und Berechnungen folgen, sei es in der RFID-Lesevorrichtung beispielsweise mittels App oder Script, oder in einer übergeordneten Steuerung (Middleware), die für mehrere RFID-Lesevorrichtungen zuständig sein kann.

Die Kommunikation zwischen der RFID-Lesevorrichtung und der mindestens ersten Adaptervorrichtung erfolgt vorzugsweise über einen Speicher der Adaptervorrichtung, insbesondere durch Kommunikation mittels eines RFID-Protokolls. Es greifen also sowohl die RFID-Lesevorrichtung als auch die erste Adaptervorrichtung, insbesondere eine Messeinheit der ersten Adaptervorrichtung, asynchron auf den Speicher zu. Die Kommunikation der RFID-Lesevorrichtung erfolgt vorzugsweise über ein RFID-Protokoll. Dafür kann der Speicher mit einer RFID-Schaltung eines RFID-Transponders ausgerüstet sein.

Die RFID-Lesevorrichtung startet vorzugsweise eine Messung der mindestens ersten Adaptervorrichtung durch Ablegen eines Startsignals in dem Speicher, wobei die Adaptervorrichtung den Speicher auf ein dort abgelegtes Startsignal prüft und bei Vorliegen eines Startsignals eine Messung der Signalleistung durchführt. Eine komplexere direkte Kommunikation zwischen der RFID-Lesevorrichtung und der Adaptervorrichtung oder deren Messeinheit ist damit nicht erforderlich. Die RFID-Lesevorrichtung teilt ihre Anforderungen einer Messung durch das Startsignal mit, die Adaptervorrichtung prüft vorzugsweise zyklisch auf ein solches Startsignal und reagiert mit Durchführen einer Messung. Nach der Messung steht der RFID-Lesevorrichtung der entsprechende Messwert zu einem beliebigen späteren Zeitpunkt zur Verfügung. Die Adaptervorrichtung kann zu dem Messwert noch einen Zeitstempel oder dergleichen speichern.

Die RFID-Lesevorrichtung erzeugt bevorzugt ein Sendesignal bekannter Sendeleistung, und währenddessen führt die erste Adaptervorrichtung eine Messung der Signalleistung durch, wobei die RFID-Lesevorrichtung einen Übertragungsverlust der Koaxialverbindung aus der bekannten Sendeleistung und einem von der ersten Adaptervorrichtung bestimmten Messwert der Signalleistung bestimmt. Das Sendesignal kann ein Dauersignal oder ein moduliertes Signal sein, der Zweck des Sendesignals ist, dass rechtzeitig für die Messung der ersten Adaptervorrichtung und über deren Dauer hinweg ein Signal der bekannten Sendeleistung durch die erste Adaptervorrichtung propagiert. Die abschließende Bestimmung des Übertragungsverlusts ergibt sich aus der bekannten Sendeleistung und dem sich bei dieser bekannten Sendeleistung einstellenden Messwerts der Signalleitung in der ersten Adaptervorrichtung, insbesondere durch Differenzbildung.

Vorzugsweise wird mit der ersten Adaptervorrichtung, während die RFID-Lesevorrichtung ein Sendesignal erzeugt, eine erste Messung der Signalleistung und zusätzlich mittels einer zweiten Adaptervorrichtung, die lösbar in die Koaxialverbindung eingesetzt ist, insbesondere einer erfindungsgemäßen zweiten Adaptervorrichtung eine zweite Messung der Signalleistung durchgeführt, wobei die RFID-Lesevorrichtung einen Übertragungsverlust der Koaxialverbindung aus je einem Messwert der beiden Messungen bestimmt. Mit dieser Ausführungsform des Verfahrens kann der Übertragungsverlust für beliebige RFID-Lesevorrichtungen bei unbekannter Sendeleistung und ohne Anpassung der RFID-Lesevorrichtung an die Koaxialverbindung bestimmt werden. Während den Messungen ist die RFID-Lesevorrichtung mit ihrer unbekannten Sendeleistung aktiv, beispielsweise durch eine kontinuierliche RFID-Abfrage beziehungsweise ein dauerhaftes Inventory. Insbesondere durch ein jeweiliges in die Speicher der Adaptervorrichtungen geschriebenes Startsignal werden die Messungen gleichzeitig oder nacheinander gestartet. Nach erfolgten Messungen wird der Übertragungsverlust aus den beiden Messwerten der beiden Adaptervorrichtungen bestimmt, insbesondere durch Differenzbildung. Für die Anordnung der beiden Adaptervorrichtung gibt es die schon im Zusammenhang mit den Ausgestaltungsmöglichkeiten der Vorrichtung diskutierten Alternativen. Der zu vermessende Abschnitt der Koaxialverbindung liegt zwischen den beiden Adaptervorrichtungen. Die zweite Adaptervorrichtung kann, wie ebenfalls schon diskutiert, bei zwei zeitlich versetzten Messungen die an neuer Position der Koaxialverbindung angeordnete erste Adaptervorrichtung oder eine physische zweite Adaptervorrichtung sein, die gemeinsam mit der ersten Adaptervorrichtung in die Koaxialverbindung eingesetzt ist. Für die Eigenschaften und Verwendung der zweiten Adaptervorrichtung gilt sinngemäß, was zu der ersten Adaptervorrichtung ausgeführt wurde.

Vorzugsweise korrigiert, sofern die mindestens erste Adaptervorrichtung im weiteren Betrieb nicht in der Koaxialverbindung verbleibt, die RFID-Lesevorrichtung einen Übertragungsverlust der Koaxialverbindung um einen bekannten Übertragungsverlust der mindestens ersten Adaptervorrichtung. Die erste Adaptervorrichtung und, sofern vorhanden, die zweite Adaptervorrichtung erzeugen jeweils einen eigenen Übertragungsverlust. Das ist aber nicht mehr relevant, wenn eine Adaptervorrichtung nur vorübergehend eingesetzt ist und nach erfolgter Messung wieder aus der Koaxialverbindung entfernt wird. Dann sinkt der Übertragungsverlust entsprechend. Wie hoch die Korrektur auszufallen hat, ist ein fester Parameter der jeweiligen Adaptervorrichtung, den die RFID-Lesevorrichtung kennt oder der insbesondere in dem Speicher der Adaptervorrichtung bereitgestellt wird.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine Blockdarstellung eines RFID-Lesers mit in die Koaxialverbindung zu dessen Antenne eingesetztem Adapter;
- Fig. 2: eine dreidimensionale Darstellung der Montage eines RFID-Lesers für eine Anwendung an einem Förderband;
- Fig. 3: eine Blockdarstellung eines Adapters;
- Fig. 4: eine Blockdarstellung einer weiteren Ausführungsform eines Adapters;
- Fig. 5: eine schematische Darstellung einer Anordnung eines Adapters in einer Koaxialverbindung für die Messung eines Übertragungsverlusts bei bekannter Sendeleistung;
- Fig. 6: eine schematische Darstellung einer Anordnung zweier Adapter in einer Koaxialverbindung für die Messung eines Übertragungsverlusts bei unbekannter Sendeleistung;
- Fig. 7: eine Darstellung einer beispielhaften Bauform eines Adapters; und
- Fig. 8: eine Darstellung einer alternativen Bauform eines Adapters.

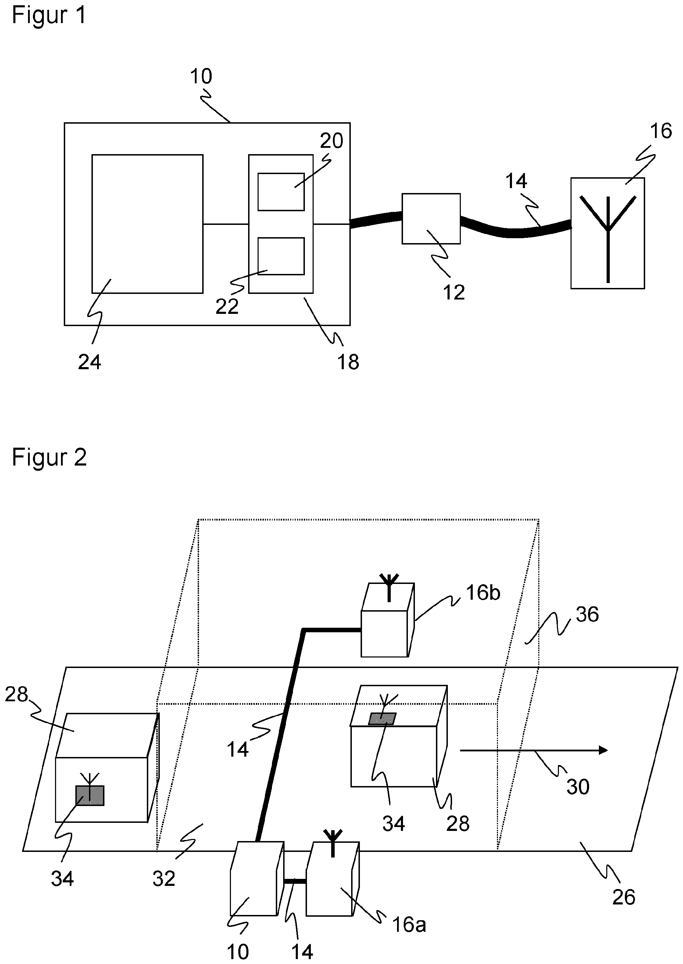

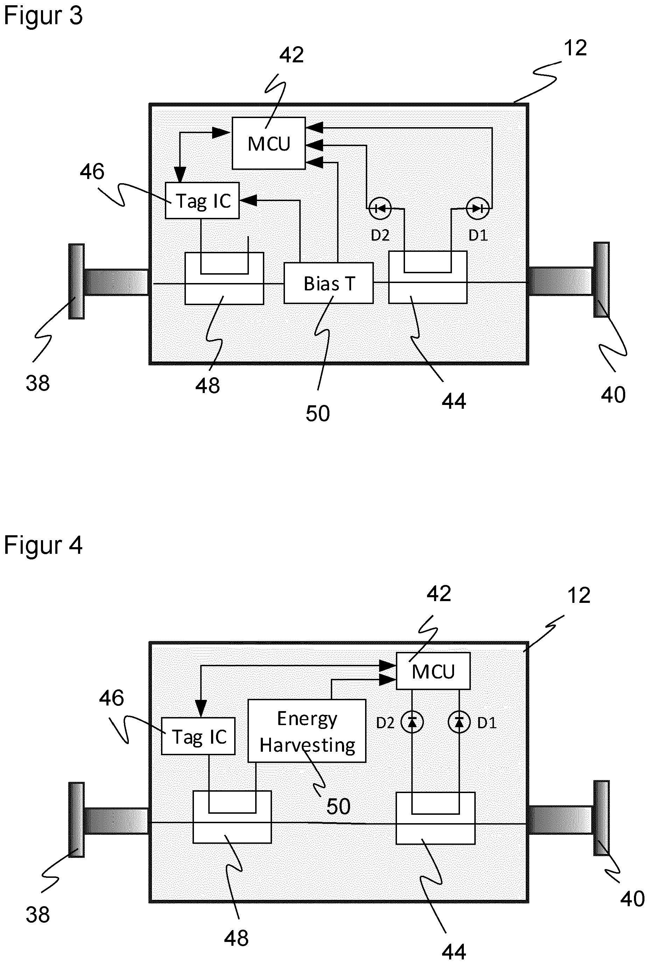

Figur 1 zeigt eine Blockdarstellung eines RFID-Lesers 10 mit einem Adapter 12, der in die Koaxialverbindung 14 zu einer an den RFID-Leser 10 angeschlossenen Antenne 16 eingesetzt ist. Der Adapter 12 ist hier nur als einfacher Block dargestellt und wird später unter Bezugnahme auf die Figuren 3 bis 6 näher erläutert. Die Antenne 16 steht stellvertretend für eine mittels Koaxialverbindung 14 an den RFID-Leser 10 angeschlossene zweite Komponente.

Der RFID-Leser 10 weist eine Sende-/Empfangseinheit 18 mit einem Sender 20 und einen Empfänger 22 auf, um von der Antenne 16 RFID-Signale zu empfangen oder über die Antenne 16 RFID-Signale abzustrahlen. Die Sende-/Empfangseinheit 18 kann als Transceiver ausgebildet sein.

Eine Steuer- und Auswertungseinheit 24 ist mit der Sende-/Empfangseinheit 18 verbunden. Sie weist mindestens einen digitalen Rechenbaustein auf, wie einen Mikroprozessor oder eine CPU (Central Processing Unit), ein FPGA (Field Programmable Gate Array), einen DSP (Digital Signal Processor), ein ASIC (Application-Specific Integrated Circuit), einen KI-Prozessor, eine NPU (Neural Processing Unit), eine GPU (Graphics Processing Unit) oder dergleichen. Die Steuer- und Auswertungseinheit 24 kann abweichend von der Darstellung zumindest teilweise extern vorgesehen sein, als Computer beliebiger Bauart einschließlich Notebooks, Smartphones, Tablets, als Steuerung, lokales Netzwerk, Edge-Device, Cloud oder sonstige Recheneinheit. Die Steuer- und Auswertungseinheit 24 erhält von dem Empfänger 22 ein den empfangenen RFID-Signalen entsprechendes elektronisches Signal beziehungsweise veranlasst über den Sender 20, ein RIFD-Signal abzustrahlen. Die Steuer- und Auswertungseinheit 24 kennt die zu verwendenden RFID-Protokolle, beispielsweise nach ISO 18000-6 oder EPC Gen2, um Information in ein RFID-Signal zu codieren oder es aus einem RFID-Signal auszulesen. RFID-Kommunikation als solche ist bekannt. Deshalb werden die erforderlichen Komponenten der Steuer- und Auswertungseinheit 24 und die für RFID-Kommunikation erforderlichen Schritte nicht näher erläutert.

Figur 2 zeigt ergänzend eine dreidimensionale Darstellung einer typischen Anwendung des RFID-Lesers 10 in stationärer Montage an einem Förderband 26. Darauf werden Objekte 28 in einer durch einen Pfeil 30 bezeichneten Richtung durch einen Lesebereich 32 gefördert. An den Objekten 28 sind die RFID-Transponder 34 angeordnet, die von dem RFID-Leser 10 ausgelesen werden, wenn sie sich in dem Lesebereich 32 befinden.

Über dem Lesebereich 32 ist vorzugsweise eine nur schematisch dargestellte Abschirmung 36 vorgesehen, welche sowohl den RFID-Leser 10 vor Störsignalen von außen als auch die Umgebung vor der elektromagnetischen Strahlung des RFID-Lesers 10 schützt. Der RFID-Leser 10 an dem so entstehenden Lesetunnel umfasst abweichend von der Darstellung der Figur 1 zwei Antennen 16a-b. Weitere RFID-Leser oder weitere Antennen sind denkbar, einschließlich interner Antennen des RFID-Lesers 10 selbst, um RFID-Signale an weiteren Positionen und aus weiteren Richtungen zu erfassen. Ebenso sind möglicherweise andere Sensoren vorgesehen, um zusätzliche Informationen über die Objekte 28 zu gewinnen, beispielsweise deren Eintritt in den und Austritt aus dem Lesebereich 32 oder das Volumen oder Gewicht der Objekte 28.

Figur 3 zeigt eine Blockdarstellung einer Ausführungsform des Adapters 12. Der Adapter 12 weist zwei Koaxialanschlüsse 38, 40 auf, vorzugsweise eines für RFI D-Anwendungen verbreiteten Typs wie R-TNC (Threaded Neill Concelman Reverse polarity). Damit kann der Adapter 12, entsprechend der sehr schematischen Darstellung der Figur 1, in die Koaxialverbindung 14 eingesetzt werden. Dabei gibt es verschiedene Möglichkeiten: Der erste Koaxialanschluss 38 kann direkt an den RFID-Leser 10 oder an eine damit verbundenes Koaxialleitung angeschlossen und der zweite Koaxialanschluss 38 direkt an die Antenne 16 oder eine damit verbundenes Koaxialleitung angeschlossen werden. Dabei weist die Koaxialverbindung 14 nur eine einzige Koaxialleitung, mehrere Koaxialleitungen als Teilabschnitte, wobei die Koaxialanschlüsse 38, 40 an den Übergängen der Koaxialleitungen angeschlossen werden können, oder in einer direkten Verbindung von RFID-Leser 10 und Antenne 16 gar kein Koaxialleitung auf.

Der Adapter 12 umfasst eine Messeinheit 42 zur Bestimmung der Signalleistung eines in Hinrichtung, Rückrichtung oder beiden Richtungen durch den Adapter 12 propagierenden Signals. Dazu erfolgt eine Signalauskopplung 44 über mindestens eine der Dioden D1, D2. Die Messeinheit 42 ist vorzugsweise dafür ausgebildet, die Maximalleistung des übertragenen Signals zu ermitteln, also beispielsweise keinen Mittelwert, um Abweichungen des gemessenen Signalleistung durch die Modulation des Sendesignals auszuschließen.

Der Adapter 12 weist vorzugsweise mindestens einen programmierbaren Speicher 46 auf, der über ein standardisiertes Protokoll über eine weitere Kopplung 48 angesprochen werden kann. Besonders bevorzugt erfolgt die Kommunikation über ein RFID-Protokoll. Dazu kann der Speicher 46 mit entsprechenden Schaltungen eines RFID-Transponders ausgestattet sein. Alternativ ist eine andere Form der Kommunikation denkbar, beispielsweise durch modulierte Spannung wie bei dem 1Wire-Protokoll. Dann muss aber der RFID-Leser 10 dieses Protokoll verstehen, während ein RFID-Protokoll ohnehin implementiert ist. In dem Speicher 46 wird vorzugsweise von dem RFID-Leser 10 ein Startsignal für eine Messung und nach erfolgter Messung von der Messeinheit 42 der Messwert für die Signalleistung abgelegt. Außerdem kann dort ein Wert für die eigene Übertragungsdämpfung des Adapters 12 hinterlegt sein.

Vorzugsweise verfügt der Adapter 12 zudem, um eine alternativ denkbare eigene Energiequelle oder Batterie zu vermeiden, über eine Schaltung 50 zur Energieversorgung aus dem auf der Koaxialverbindung 14 übertragenen Signal. In der Ausführungsform gemäß Figur 3 handelt es sich um eine Versorgung mittels Phantom- oder Fernspeisung beispielsweise durch ein Bias-T.

Figur 4 zeigt eine Blockdarstellung einer weiteren Ausführungsform des Adapters 12. Im Unterschied zu Figur 3 ist hier keine Phantomspeisung erforderlich. Die Schaltung 50 zur Energieversorgung weist einen Gleichrichter oder eine Ladungspumpe auf, um die Versorgung mittels Energy Harvesting zu gewährleisten. Dazu weist die Schaltung 50 einen nicht separat gezeigten Energiespeicher auf, wie einen Kondensator, der durch das Energy Harvesting geladen wird.

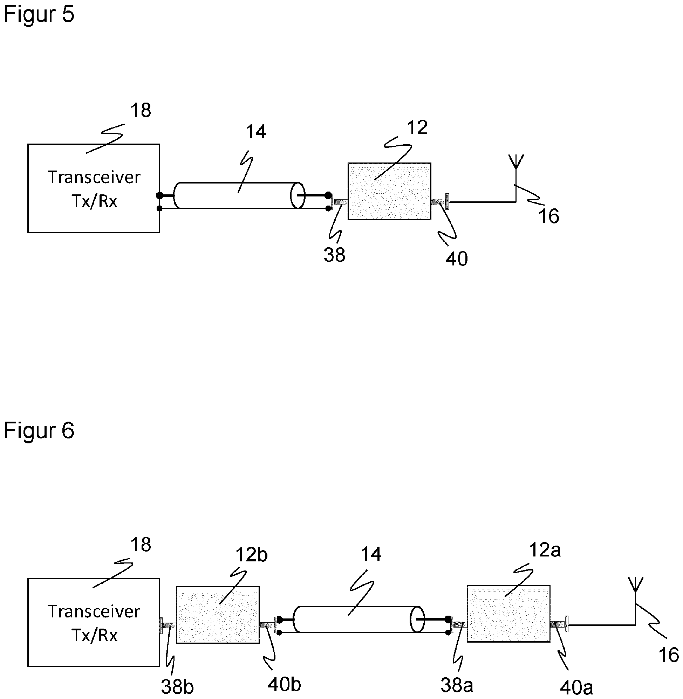

Figur 5 zeigt eine schematische Darstellung einer Anordnung des Adapters 12 in einer Koaxialverbindung 14 für die Messung eines Übertragungsverlusts beziehungsweise der Antennenanpassung bei bekannter Sendeleistung und einem angepassten RFID-Leser 10. Es genügt dann eine Messung mit einem Adapter 12, der vorzugsweise am der Antenne 16 zugewandten Ende der Koaxialverbindung angeschlossen ist. Bei anderer Anordnung wird nur der Übertragungsverlust des Abschnitts bis zu dem Adapter 12 bestimmt, was beispielsweise im Falle einer mehrteiligen Koaxialverbindung sinnvoll sein kann.

Ein beispielhafter Ablauf beginnt damit, dass der RFID-Leser 10 ein Startsignal insbesondere mit Startzeitpunkt in dem Speicher 46 des Adapters 12 ablegt. Dazu wird das Sendesignal des RFID-Lesers 10 eingeschaltet, der damit auf den Speicher 46 zugreift. In dem Adapter 12 fragt die Messeinheit 42 den Speicher 46 in regelmäßigen Abständen ab und erkennt deshalb eigenständig und asynchron die Zustandsänderung im Speicher 46. Sie startet sofort, mit allgemein vorab vereinbarter Verzögerung oder zu einem mit dem Startsignal abgelegten Zeitpunkt eine Messung der Sendeleistung. Der RFI D-Leser 10 ist entsprechend spätestens seit dem Ablegen des Startsignals, mit der vereinbarten Verzögerung oder zu dem mit abgelegtem Zeitpunkt auf seine beispielsweise durch werkseitige Kalibrierung bekannte Sendeleistung eingestellt und hat sein Sendesignal dieser Sendeleistung zumindest für die Dauer der Messung eingeschaltet. Die Messung des Signalpegels erfolgt daher bei der bekannten Sendeleistung. Die Messeinheit 42 legt die von ihr bestimmte Signalleistung beziehungsweise den gemessenen maximalen Signalpegel in dem Speicher 46 ab. Der RFID-Leser 10 greift auf den Speicher 46 zu, um den Messwert auszulesen. Dabei kann ein Signal vereinbart sein, mit dem die Messeinheit 42 das Ende der Messung signalisiert, wobei dieses Signal schlicht in dem Messwert selbst im Gegensatz beispielsweise zu einem leeren Speicherplatz bestehen kann.

Die wie zu Figur 1 beschrieben womöglich externe Steuer- und Auswertungseinheit 24 des RFI D-Leser 10 bestimmt aus Differenz der bekannten Sendeleistung und des Messwerts des Adapters 12 die Dämpfung der Koaxialverbindung 14 beziehungsweise den Übertragungsverlust. Optional erfolgt abschließend noch eine Abfrage, ob der Adapter 12 für den weiteren Betrieb in der Koaxialverbindung 14 verbleibt. Der Übertragungsverlust kann, sofern der Adapter 12 nun demontiert wird, noch um den eigenen Übertragungsverlust des Adapters 12 korrigiert werden, denn dieser Anteil des Übertragungsverlusts entfällt nach der Demontage. Der entsprechende Wert kann in dem RFID-Leser 10 parametriert oder aus dem Speicher 46 ausgelesen werden. Durch das Entfernen des Adapters 12 kann dieser an anderer Stelle erneut verwendet werden. Andererseits ist der Verbleib des Adapters für periodisch wiederholte Messungen mit Prüfung auf Veränderungen durchaus von diagnostischem Vorteil (predictive maintenance).

Figur 6 zeigt eine schematische Darstellung einer Anordnung zweier Adapter 12a-b in einer Koaxialverbindung 14 für die Messung eines Übertragungsverlusts bei unbekannter Sendeleistung und beliebigem, nicht oder allenfalls zufällig angepasstem RFID-Leser 10. Die beiden Adapter 12a-b werden vorzugsweise an den beiden Enden der Koaxialverbindung 14 eingesetzt, also bei der Antenne 16 und bei dem RFID-Leser 10. Ansonsten wird der Übertragungsverlust nicht in der gesamten Koaxialverbindung 14, sondern nur in dem Teilabschnitt zwischen den Adaptern 12a-b bestimmt. Alternativ zu einer gemeinsamen physischen Präsenz zweier Adapter 12a-b ist denkbar, denselben Adapter 12 nacheinander für eine jeweilige Messung an die beiden angegebenen Positionen zu bringen.

Ein beispielhafter Ablauf ähnelt im Großen und Ganzen demjenigen, der zu Figur 5 beschrieben wurde, so dass nur auf die Unterschiede näher eingegangen wird. Das Startsignal wird nun in beiden Speichern 46 der Adapter 12a-b abgelegt. Die dadurch ausgelösten Messungen erfolgen wahlweise gleichzeitig oder nacheinander. Die jeweilige Messeinheit 42 der Adapter 12a-b fragt ihren Speicher 46 in regelmäßigen Abständen ab und startet gegebenenfalls zum zugehörigen Zeitpunkt ihre Messung. Der RFID-Leser 10 ist in einen Modus für kontinuierliche Abfrage gesetzt (dauerhaftes Inventory) oder sorgt auf andere Weise dafür, dass ein Signal anliegt. Es ist denkbar, der Messung eine Phase bei eingeschaltetem Sendesignal vorausgehen zu lassen, in dem eine Ladungspumpe gemäß Figur 4 den Energiespeicher auflädt. Dann kann die Ladungspumpe auch rechtzeitig abgeschaltet werden, um die Messung nicht zu beeinflussen. Nachdem beide Messungen durchgeführt wurden, liest der RFID-Leser die entsprechenden Messwerte beider Adapter 12a-b aus. Die Dämpfung oder der Übertragungsverlust der Koaxialverbindung 14 ergibt sich aus der Differenz der beiden Messwerte. Abschließend kann optional eine Abfrage folgen, ob die Adapter 12a-b in der Koaxialverbindung 14 verbleiben oder einer der Adapter 12a-b verbleibt, um gegebenenfalls um den Übertragungsverlust eines wieder entnommenen Adapters 12a-b zu korrigieren.

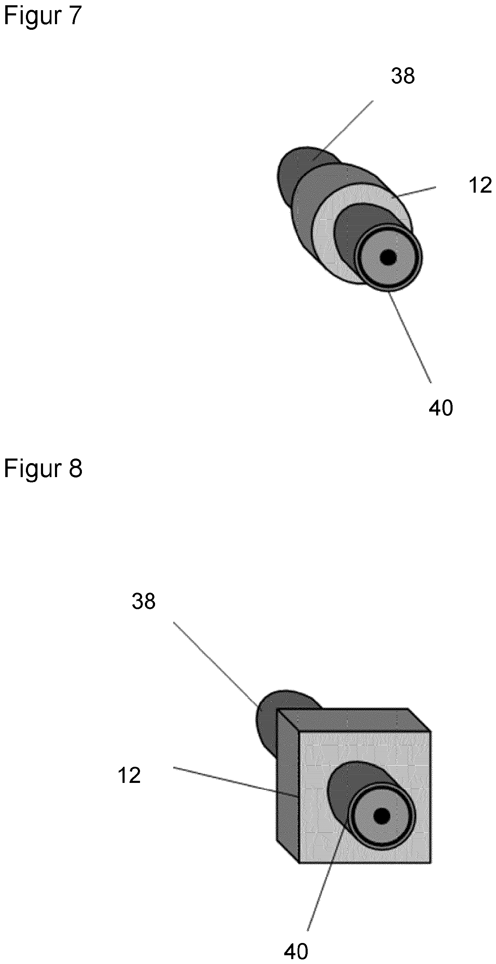

Die Figuren 7 und 8 zeigen zwei beispielhafte Bauformen des Adapters 12 mit weitgehend universell verwendbaren Koaxialanschlüssen 38, 40. Der Adapter 12 beansprucht im Wesentlichen denselben Montageraum wie ein kurzer Abschnitt der Koaxialverbindung 14 und ist sehr einfach und intuitiv handhabbar. Die weiteren Abläufe erfolgen vorzugsweise automatisch, es ist lediglich ein entsprechendes Steuerungsprogramm in dem RFID-Leser 10 oder einer externen Steuer- und Auswertungseinheit 24 einer übergeordneten Recheneinheit erforderlich. Die Erfindung ist am Beispiel eines RFID-Lesers 10 beschrieben, aber ebenso nutzbar für andere Transceiver oder Funkanlagen beziehungsweise Koaxialverbindungen 14 zwischen Komponenten davon.

## Patentansprüche

1. RFID-Lesevorrichtung (10), die eine zweite Vorrichtung (16), insbesondere Antenne, und eine Koaxialverbindung (14) zu der zweiten Vorrichtung (16) sowie mindestens eine erste Adaptervorrichtung (12) zur Vermessung der Signalleistung in der Koaxialverbindung (14) aufweist, wobei die erste Adaptervorrichtung (12) einen ersten Koaxialanschluss (38) und einen zweiten Koaxialanschluss (40) zum Einsetzen der ersten Adaptervorrichtung (12) in die Koaxialverbindung (14) sowie eine Messeinheit (42) aufweist, die dafür ausgebildet ist, die Signalleistung eines von dem ersten Koaxialanschluss (38) zu dem zweiten Koaxialanschluss (40) und/oder umgekehrt propagierenden Signals zu bestimmen, wobei der erste Koaxialanschluss (38) und der zweite Koaxialanschluss (40) lösbar sind, so dass die erste Adaptervorrichtung (12) wahlweise in die Koaxialverbindung (14) eingesetzt oder daraus entfernt werden kann, und wobei die erste Adaptervorrichtung (12) mit ihrem ersten Koaxialanschluss (38) und zweiten Koaxialanschluss (40) an einem bezüglich der RFID-Lesevorrichtung (10) fernen Ende des zu vermessenden Abschnitts der Koaxialverbindung (14) in die Koaxialverbindung (14) eingesetzt ist.

2. RFID-Lesevorrichtung (10) nach Anspruch 1,
wobei die Messeinheit (42) dafür ausgebildet ist, einen Maximalwert der Signalleistung zu bestimmen.

3. RFID-Lesevorrichtung (10) nach Anspruch 1 oder 2,
wobei die erste Adaptervorrichtung (12) eine Energieversorgungseinheit (50) aufweist, mit der sich die erste Adaptervorrichtung (12) aus dem Signal auf der Koaxialverbindung (14) propagierenden Signal selbst versorgt.

4. RFID-Lesevorrichtung (10) nach einem der vorhergehenden Ansprüche,
wobei die erste Adaptervorrichtung (12) einen Speicher (46) aufweist, in dem die Messeinheit (42) einen Messwert für die Signalleistung ablegt.

5. RFID-Lesevorrichtung (10) nach Anspruch 4,
wobei der Speicher (46) mittels eines RFID-Protokolls auslesbar ist, insbesondere eine RFID-Transponder-Schaltung aufweist.

6. RFID-Lesevorrichtung (10) nach Anspruch 5,
wobei die Messeinheit (42) dafür ausgebildet ist, den Speicher (46) auf ein dort abgelegtes Startsignal zu prüfen und bei Vorliegen eines Startsignals eine Messung der Signalleistung durchzuführen.

7. RFID-Lesevorrichtung (10) nach einem der vorhergehenden Ansprüche, wobei die Sendeleistung der RFID-Lesevorrichtung (10) in der RFID-Lesevorrichtung (10) bekannt und die RFID-Lesevorrichtung (10) dafür ausgebildet ist, einen Übertragungsverlust der Koaxialverbindung (14) aus der bekannten Sendeleistung und einem Messwert der ersten Adaptervorrichtung (12) zu bestimmen.

8. RFID-Lesevorrichtung (10) nach einem der Ansprüche 1 bis 6,
die eine zweite Adaptervorrichtung (12b) zur Vermessung der Signalleistung in der Koaxialverbindung (14) aufweist, wobei die zweite Adaptervorrichtung (12b) an einem bezüglich der RFID-Lesevorrichtung (10) nahen Ende des zu vermessenden Abschnitts der Koaxialverbindung (14) angeordnet und die RFID-Lesevorrichtung (10) dafür ausgebildet ist, einen Übertragungsverlust der Koaxialverbindung (14) aus Messwerten der ersten Adaptervorrichtung (12a) und der zweiten Adaptervorrichtung (12b) zu bestimmen.

9. Verfahren zur Vermessung der Signalleistung in einer Koaxialverbindung (14) von einer RFID-Lesevorrichtung (10) zu einer zweiten Vorrichtung (16), insbesondere Antenne, mittels mindestens einer ersten Adaptervorrichtung (12, 12a), die mit einem ersten Koaxialanschluss (38) und einem zweiten Koaxialanschluss (40) lösbar in die Koaxialverbindung (14) eingesetzt ist, wobei die RFID-Lesevorrichtung (10) eine Messung der Signalleistung startet, die erste Adaptervorrichtung (12, 12a) daraufhin die Signalleistung eines durch die erste Adaptervorrichtung (12, 12a) propagierenden Signals der RFID-Lesevorrichtung (10) bestimmt und die RFID-Lesevorrichtung (10) dann einen Messwert der ersten Adaptervorrichtung (12, 12a) ausliest.

10. Verfahren nach Anspruch 9,
wobei die Kommunikation zwischen der RFID-Lesevorrichtung (10) und der mindestens ersten Adaptervorrichtung (12, 12a) über einen Speicher (46) der Adaptervorrichtung (12, 12a) erfolgt, insbesondere durch Kommunikation mittels eines RFID-Protokolls.

11. Verfahren nach Anspruch 9 oder 10,
wobei die RFID-Lesevorrichtung (10) eine Messung der mindestens ersten Adaptervorrichtung (12, 12a) durch Ablegen eines Startsignals in dem Speicher (46) startet und wobei die Adaptervorrichtung (12, 12a) den Speicher (46) auf ein dort abgelegtes Startsignal prüft und bei Vorliegen eines Startsignals eine Messung der Signalleistung durchführt.

12. Verfahren nach einem der Ansprüche 9 bis 11,
wobei die RFID-Lesevorrichtung (10) ein Sendesignal bekannter Sendeleistung erzeugt und währenddessen die erste Adaptervorrichtung (12) eine Messung der Signalleistung durchführt, und wobei die RFID-Lesevorrichtung (10) einen Übertragungsverlust der Koaxialverbindung (14) aus der bekannten Sendeleistung und einem von der ersten Adaptervorrichtung (12) bestimmten Messwert der Signalleistung bestimmt.

13. Verfahren nach einem der Ansprüche 9 bis 11,
wobei mit der ersten Adaptervorrichtung (12a), während die RFID-Lesevorrichtung (10) ein Sendesignal erzeugt, eine erste Messung der Signalleistung und zusätzlich mit einer zweiten Adaptervorrichtung (12b), die lösbar in die Koaxialverbindung (14) eingesetzt ist, eine zweite Messung der Signalleistung durchgeführt wird und wobei die RFID-Lesevorrichtung (10) einen Übertragungsverlust der Koaxialverbindung (14) aus je einem Messwert der beiden Messungen bestimmt.

14. Verfahren nach einem der Ansprüche 9 bis 13,
wobei, sofern die mindestens erste Adaptervorrichtung (12, 12a-b) im weiteren Betrieb nicht in der Koaxialverbindung (14) verbleibt, die RFID-Lesevorrichtung (10) einen Übertragungsverlust der Koaxialverbindung (14) um einen bekannten Übertragungsverlust der mindestens ersten Adaptervorrichtung (12, 12a-b) korrigiert.

## Claims

1. An RFID reading device (10) comprising a second device (16), in particular an antenna, and a coaxial connection (14) to the second device (16) and at least one first adapter device (12) for measuring the signal power in the coaxial connection (14), the first adapter device (12) comprising a first coaxial connector (38) and a second coaxial connector (40) for inserting the first adapter device (12) into the coaxial connection (14) and a measuring unit (42) configured for determining the signal power of a signal propagating from the first coaxial connector (38) to the second coaxial connector (40) and/or vice versa, wherein the first coaxial connector (38) and the second coaxial connector (40) are detachable so that the first adapter device (12) can be selectively inserted into or removed from the coaxial connection (14), and wherein the first adapter device (12) is inserted into the coaxial connection (14) with its first coaxial connector (38) and second coaxial connector (40) at an end of the section of the coaxial connection (14) to be measured which is remote with respect to the RFID reading device (10).

2. The RFID reading device (10) according to claim 1,
wherein the measuring unit (42) is configured to determine a maximum value of the signal power.

3. The RFID reader device (10) according to claim 1 or 2,
wherein the first adapter device (12) comprises a power supply unit (50) with which the first adapter device (12) powers itself from the signal propagating on the coaxial connection (14).

4. The RFID reader device (10) according to any of the preceding claims,
wherein the first adapter device (12) comprises a memory (46) in which the measuring unit (42) stores a measured value for the signal power.

5. The RFID reading device (10) according to claim 4,
wherein the memory (46) can be read by means of an RFID protocol, in particular comprises an RFID transponder circuit.

6. The RFID reading device (10) according to claim 5,
wherein the measuring unit (42) is configured to check the memory (46) for a start signal stored therein and to perform a measurement of the signal power if a start signal is present.

7. The RFID reader device (10) according to any of the preceding claims,
wherein the transmission power of the RFID reading device (10) in the RFID reading device (10) is known and the RFID reading device (10) is configured to determine a transmission loss of the coaxial connection (14) from the known transmission power and a measured value of the first adapter device (12).

8. The RFID reading device (10) according to any of claims 1 to 6,
comprising a second adapter device (12b) for measuring the signal power in the coaxial connection (14), the second adapter device (12b) being arranged at an end of the section of the coaxial connection (14) to be measured which is close with respect to the RFID reading device (10), and the RFID reading device (10) being configured to determine a transmission loss of the coaxial connection (14) from measured values of the first adapter device (12a) and the second adapter device (12b).

9. A method for measuring the signal power in a coaxial connection (14) from an RFID reading device (10) to a second device (16), in particular an antenna, by means of at least one first adapter device (12, 12a), which is detachably inserted into the coaxial connection (14) with a first coaxial connector (38) and a second coaxial connector (40), wherein the RFID reading device (10) starts a measurement of the signal power, the first adapter device (12, 12a) then determines the signal power of a signal of the RFID reading device (10) propagating through the first adapter device (12, 12a) and the RFID reading device (10) then reads out a measured value of the first adapter device (12, 12a).

10. The method according to claim 9,
wherein the communication between the RFID reading device (10) and the at least first adapter device (12, 12a) takes place via a memory (46) of the adapter device (12, 12a), in particular by communication by means of an RFID protocol.

11. The method according to claim 9 or 10,
wherein the RFID reading device (10) starts a measurement of the at least first adapter device (12, 12a) by storing a start signal in the memory (46) and wherein the adapter device (12, 12a) checks the memory (46) for a start signal stored therein and performs a measurement of the signal power if a start signal is present.

12. The method according to any of claims 9 to 11,
wherein the RFID reading device (10) generates a transmission signal of known transmission power and meanwhile the first adapter device (12) performs a measurement of the signal power, and wherein the RFID reading device (10) determines a transmission loss of the coaxial connection (14) from the known transmission power and a measured value of the signal power determined by the first adapter device (12).

13. The method according to one of claims 9 to 11,
wherein a first measurement of the signal power is carried out with the first adapter device (12a), while the RFID reading device (10) generates a transmission signal, and additionally a second measurement of the signal power is carried out with a second adapter device (12b), which is detachably inserted into the coaxial connection (14), and wherein the RFID reading device (10) determines a transmission loss of the coaxial connection (14) from a measured value of each of the two measurements.

14. The method according to any one of claims 9 to 13,
wherein, if the at least first adapter device (12, 12a-b) does not remain in the coaxial connection (14) during further operation, the RFID reading device (10) corrects a transmission loss of the coaxial connection (14) by a known transmission loss of the at least first adapter device (12, 12a-b).

## Revendications

1. Dispositif de lecture RFID (10) comprenant un deuxième dispositif (16), en particulier une antenne, et une connexion coaxiale (14) vers le deuxième dispositif (16) ainsi qu'au moins un premier dispositif adaptateur (12) pour mesurer la puissance du signal dans la connexion coaxiale (14),
dans lequel
le premier dispositif adaptateur (12) comprend un premier raccord coaxial (38) et un deuxième raccord coaxial (40) pour insérer le premier dispositif adaptateur (12) dans la connexion coaxiale (14), ainsi qu'une unité de mesure (42) conçue pour déterminer la puissance d'un signal se propageant du premier raccord coaxial (38) au deuxième raccord coaxial (40) et/ou inversement,
le premier raccord coaxial (38) et le deuxième raccord coaxial (40) sont amovibles, de sorte que le premier dispositif adaptateur (12) peut au choix être inséré dans la connexion coaxiale (14) ou être retiré de celle-ci, et le premier dispositif adaptateur (12) est inséré, avec son premier raccord coaxial (38) et avec son deuxième raccord coaxial (40), dans la connexion coaxiale (14) à une extrémité, distale par rapport au dispositif de lecture RFID (10), de la section à mesurer de la connexion coaxiale (14).

2. Dispositif de lecture RFID (10) selon la revendication 1,
dans lequel l'unité de mesure (42) est conçue pour déterminer une valeur maximale de la puissance du signal.

3. Dispositif de lecture RFID (10) selon la revendication 1 ou 2,
dans lequel le premier dispositif adaptateur (12) comprend une unité d'alimentation en énergie (50) permettant au premier dispositif adaptateur (12) de s'auto-alimenter à partir du signal se propageant sur la connexion coaxiale (14).

4. Dispositif de lecture RFID (10) selon l'une des revendications précédentes, dans lequel le premier dispositif adaptateur (12) comprend une mémoire (46) dans laquelle l'unité de mesure (42) enregistre une valeur de mesure de la puissance du signal.

5. Dispositif de lecture RFID (10) selon la revendication 4,
dans lequel la mémoire (46) peut être lue au moyen d'un protocole RFID et présente en particulier un circuit de transpondeur RFID.

6. Dispositif de lecture RFID (10) selon la revendication 5,
dans lequel l'unité de mesure (42) est conçue pour vérifier la mémoire (46) quant à la présence d'un signal de démarrage enregistré, et pour effectuer, en cas de présence d'un signal de démarrage, une mesure de la puissance du signal.

7. Dispositif de lecture RFID (10) selon l'une des revendications précédentes, dans lequel la puissance d'émission du dispositif de lecture RFID (10) est connue dans le dispositif de lecture RFID (10), et le dispositif de lecture RFID (10) est conçu pour déterminer une perte de transmission de la connexion coaxiale (14) à partir de la puissance d'émission connue et d'une valeur de mesure du premier dispositif adaptateur (12).

8. Dispositif de lecture RFID (10) selon l'une des revendications 1 à 6, comprenant un deuxième dispositif adaptateur (12b) pour mesurer la puissance du signal dans la connexion coaxiale (14), le deuxième dispositif adaptateur (12b) étant disposé à une extrémité, proximale par rapport au dispositif de lecture RFID (10), de la section à mesurer de la connexion coaxiale (14), et le dispositif de lecture RFID (10) étant conçu pour déterminer une perte de transmission de la connexion coaxiale (14) à partir des valeurs de mesure du premier dispositif adaptateur (12a) et du deuxième dispositif adaptateur (12b).

9. Procédé de mesure de la puissance du signal dans une connexion coaxiale (14) d'un dispositif de lecture RFID (10) vers un deuxième dispositif (16), en particulier une antenne, au moyen d'au moins un premier dispositif adaptateur (12, 12a) qui est inséré, avec un premier raccord coaxial (38) et avec un deuxième raccord coaxial (40), de manière amovible dans la connexion coaxiale (14),
dans lequel le dispositif de lecture RFID (10) démarre une mesure de la puissance du signal, le premier dispositif adaptateur (12, 12a) détermine ensuite la puissance d'un signal du dispositif de lecture RFID (10) se propageant à travers le premier dispositif adaptateur (12, 12a), et le dispositif de lecture RFID (10) lit ensuite une valeur de mesure du premier dispositif adaptateur (12, 12a).

10. Procédé selon la revendication 9,
dans lequel la communication entre le dispositif de lecture RFID (10) et le au moins premier dispositif adaptateur (12, 12a) est réalisée par l'intermédiaire d'une mémoire (46) du dispositif adaptateur (12, 12a), en particulier par communication au moyen d'un protocole RFID.

11. Procédé selon la revendication 9 ou 10,
dans lequel le dispositif de lecture RFID (10) démarre une mesure d'au moins le premier dispositif adaptateur (12, 12a) en enregistrant un signal de démarrage dans la mémoire (46), et
le dispositif adaptateur (12, 12a) vérifie la mémoire (46) quant à la présence d'un signal de démarrage enregistré, et effectue, en cas de présence d'un signal de démarrage, une mesure de la puissance du signal.

12. Procédé selon l'une des revendications 9 à 11,
dans lequel le dispositif de lecture RFID (10) génère un signal d'émission de puissance d'émission connue pendant que le premier dispositif adaptateur (12) effectue une mesure de la puissance du signal, et
le dispositif de lecture RFID (10) détermine une perte de transmission de la connexion coaxiale (14) à partir de la puissance d'émission connue et d'une valeur de mesure de la puissance du signal déterminée par le premier dispositif adaptateur (12).

13. Procédé selon l'une des revendications 9 à 11,
dans lequel, pendant que le dispositif de lecture RFID (10) génère un signal d'émission, une première mesure de la puissance du signal est effectuée au moyen du premier dispositif adaptateur (12a), et, en supplément, une deuxième mesure de la puissance du signal est effectuée au moyen du deuxième dispositif adaptateur (12b) inséré de manière amovible dans la connexion coaxiale (14), et
le dispositif de lecture RFID (10) détermine une perte de transmission de la connexion coaxiale (14) à partir d'une valeur de mesure de chacune des deux mesures.

14. Procédé selon l'une des revendications 9 à 13,
dans lequel, dans la mesure où ledit au moins premier dispositif adaptateur (12, 12a-b) ne reste pas dans la connexion coaxiale (14) pendant la suite du fonctionnement, le dispositif de lecture RFID (10) corrige une perte de transmission de la connexion coaxiale (14) d'une perte de transmission connue dudit au moins premier dispositif adaptateur (12, 12a-b).
